# EUROPEAN PATENT APPLICATION

(11) **EP 4 379 824 A1**
(43) Date of publication of application: **05.06.2024**
(21) Application number: 22849911.7
(22) Date of filing: 28.07.2022
(51) Int. Cl.: H01L 33/48, H01L 23/08, H01L 33/54, H01L 23/04, H01L 33/56, H01L 33/50, G02F 1/1335, G02F 1/13357

(54) **LIGHT EMITTING DIODE PACKAGE AND BACKLIGHT UNIT INCLUDING SAME**

(30) Priority: 28.07.2021 US 202163226480 P; 13.10.2021 US 202163255233 P; 27.07.2022 US 202217875332
(71) Applicant: Seoul Semiconductor Co., Ltd., Gyeonggi-do 15429 (KR)
(72) Inventor: SHIN, Dong Sun, Ansan-si Gyeonggi-do 15429 (KR); JANG, Seung Sin, Ansan-si Gyeonggi-do 15429 (KR)
(74) Representative: Isarpatent
(86) International application number: PCT/KR2022/011145
(87) International publication number: WO 2023/008935

(57) **Abstract**

A light emitting diode package includes: a housing including a cavity region therein; a light emitting diode chip mounted on one surface in the cavity of the housing; and a resin part formed in the cavity region to cover a light emitting surface of the light emitting diode chip. The housing includes a first surface and a second surface which are perpendicular to a width direction of the housing and spaced apart from each other, and a third surface and a fourth surface which are perpendicular a longitudinal direction of the housing and spaced apart from each other, and the first surface and the second surface surround the resin part while the third surface and the fourth surface expose side surfaces of the resin part.

## Description

### TECHNICAL FIELD

The present disclosure relates to a light emitting diode package, and more particularly, to a light emitting diode package and a backlight unit including the same.

### BACKGROUND ART

Light emitting devices are semiconductor devices using light emitting diodes which are inorganic light sources, and are used in various technical fields such as displaying apparatuses, automobile lamps, general lighting, and the like. Light emitting diodes have advantages such as longer lifespan, lower power consumption, and quicker response than conventional light sources, and thus, the light emitting diodes have been replacing the conventional light sources.

The conventional light emitting diode package is implemented as a single light emitting surface structure in which a light emitting surface has only an upward direction. In this case, since the light emitted from each light emitting diode chip of the light emitting diode package is concentrated only on an upper center of the light emitting surface, there may occur a hot spot phenomenon in which a central portion corresponding to each light emitting surface becomes bright and a mura phenomenon in which the periphery of the central portion becomes dark. In addition, such hot spot and mura phenomena may cause a phenomenon of insufficient light coverage of a backlight unit including the conventional light emitting diode package.

### DETAILED DESCRIPTION OF INVENTION

### TECHNICAL PROBLEMS

An embodiment of the present disclosure aims to provide a light emitting diode package capable of improving the hot spot problem and the mura phenomenon by removing a housing portion surrounding at least one side portion of a light emitting surface of at least one light emitting diode chip mounted on the light emitting diode package and exposing the light emitting surface not only in an upward direction but also in lateral directions in which the housing portion is removed to enlarge a beam angle of light and reduces the concentration of light at the center of the light emitting surface of the light emitting diode chip.

Another embodiment of the present disclosure aims to provide a backlight unit capable of overcoming an insufficient light coverage of a backlight unit by employing the light emitting diode package capable of improving the hot spot problem and the mura phenomenon.

Still another embodiment of the present disclosure aims to provide a backlight unit capable of employing a high-efficiency light emitting diode package by improving heat dissipation efficiency.

### TECHNICAL SOLUTION

A light emitting diode package according to a first embodiment of the present disclosure includes: a housing including a cavity region therein; a light emitting diode chip mounted on one surface in the cavity of the housing; and a resin part formed in the cavity region to cover a light emitting surface of the light emitting diode chip, wherein the housing includes a first surface and a second surface which are perpendicular to a width direction of the housing and spaced apart from each other, and a third surface and a fourth surface which are perpendicular a longitudinal direction of the housing and spaced apart from each other, and wherein the first surface and the second surface surround the resin part while the third surface and the fourth surface expose side surfaces of the resin part.

The housing may be formed of a silicon or epoxy material having a white color.

The housing may include: a mounting portion on which the light emitting diode chip is mounted; a first sidewall portion and a second sidewall portion extending from the mounting portion toward one end and the other end in the width direction of the housing, respectively; a first step portion extending from the first sidewall portion to the first surface and a second step portion extending from the second sidewall portion to the second surface; a third sidewall portion and a fourth sidewall portion extending from the mounting portion toward one end and the other end in the longitudinal direction of the housing, respectively; and a third step portion extending from the third sidewall portion to the third surface and a fourth step portion extending from the fourth sidewall portion to the fourth surface.

The mounting portion may include a flat surface, the third and fourth sidewall portions may include inclined surfaces having a first inclination angle, and the first and second sidewall portions may include inclined surfaces having a second inclination angle, and the first inclination angle may have a smaller value than the second inclination angle.

A first distance from a center of a mounting region of the light emitting diode chip to the third sidewall portion may be greater than a second distance from the third sidewall portion to the third step portion, and the second distance may be greater than a third distance from the third step portion to the third surface of the housing.

A fourth distance from the first sidewall portion to the first step portion may be smaller than the second distance from the third sidewall portion to the third step portion.

The light emitting diode chip may be disposed at a center of the cavity region in the width direction of the housing, and be disposed close to the third sidewall portion or the fourth sidewall portion at the center of the cavity region in the longitudinal direction of the housing.

The light emitting diode package further includes electrodes electrically connected to the light emitting diode chip, wherein the electrodes may be respectively exposed on the third surface and the fourth surface of the housing, each of the electrodes being disposed at a position spaced apart from a bottom surface of the housing by a preset height, and formed to be surrounded by the housing.

A height of an exposed region of the resin part which is exposed through the third surface and the fourth surface of the housing may be about 50% or less of an overall height of the light emitting diode package.

The resin part may have a structure in which an inner surface is depressed downward so that the resin part is exposed to emit light.

The resin part may include a transparent silicon or a phosphor for wavelength conversion.

A light emitting diode package according to a second embodiment of the present disclosure includes: a housing including a plurality of cavity regions therein and a partition wall formed between the cavity regions to separate the plurality of cavity regions; a plurality of light emitting diode chips respectively mounted on one surfaces inside the plurality of cavity regions; and a resin part formed in each of the cavity regions to cover a light emitting surface of each of the light emitting diode chips, wherein the housing includes a first surface perpendicular to a width direction of the housing, a second surface parallel to the first surface, a third surface perpendicular to a longitudinal direction of the housing, and a fourth surface parallel to the third surface, and wherein the first surface and the second surface surround the resin parts while the third surface and the fourth surface expose side surfaces of the resin parts.

Each of the cavity regions may include: a mounting portion on which the light emitting diode chip is mounted; a first sidewall portion and a second sidewall portion extending from the mounting portion toward one end and the other end in the width direction of the housing, respectively; a first step portion extending from the first sidewall portion to the first surface and a second step portion extending from the second sidewall portion to the second surface; a third side wall portion or a fourth side wall portion extending from the mounting portion toward one end and the other end in the longitudinal direction of the housing, respectively; and a third step portion extending from the third sidewall portion to the third surface or a fourth step portion extending from the fourth sidewall portion to the fourth surface.

The light emitting diode chip may be disposed at a center of the cavity region in the first direction and the second direction, and disposed closer to the third sidewall portion or the third sidewall portion in the third direction or the fourth direction at the center of the cavity region.

An inclination angle of the partition wall may be greater than an inclination angle of the third sidewall portion extending in the third direction or the fourth sidewall portion extending in the fourth direction of the housing.

The partition wall may have a height higher than that of the third step portion and the fourth step portion.

The plurality of light emitting diode chips may include two light emitting diode chips, the two light emitting diode chips may be mounted with the partition wall interposed therebetween, and the two light emitting diode chips may be surrounded by a structure having an open end surface, an electrode being exposed through the open end surface.

A backlight unit according to a third embodiment of the present disclosure includes: a plurality of light emitting diode packages for emitting light in at least three directions; a circuit board on which the light emitting diode packages are mounted; a light guide plate for changing a path of light incident from the light emitting diode packages; a reflective sheet disposed on a lower surface of the light guide plate; and at least one optical sheet disposed on an upper surface of the light guide plate, wherein each of the light emitting diode packages includes: a housing including a cavity region therein; a light emitting diode chip mounted on one surface of the cavity of the housing; and a resin part formed in the cavity region to cover a light emitting surface of the light emitting diode chip, wherein the housing includes a first surface perpendicular to a width direction of the housing, a second surface parallel to the first surface, a third surface perpendicular to a longitudinal direction of the housing, and a fourth surface parallel to the third surface including, wherein the first surface and the second surface surround the resin part while the third surface and the fourth surface expose side surfaces of the resin part, and wherein the adjacent light emitting diode packages are arranged in such a way that the exposed side surfaces of the resin parts face each other.

The housing may include: a mounting portion on which the light emitting diode chip is mounted; a first sidewall portion and a second sidewall portion extending from the mounting portion toward one end and the other end in the width direction of the housing, respectively; a first step portion extending from the first sidewall portion to the first surface and a second step portion extending from the second sidewall portion to the second surface; a third side wall portion and a fourth side wall portion extending from the mounting portion toward one end and the other end in the longitudinal direction of the housing, respectively; and a third step portion extending from the third sidewall portion to the third surface and a fourth step portion extending from the fourth sidewall portion to the fourth surface.

The cavity region of the housing may include a plurality of cavity regions, and the housing may further include a partition wall formed between the cavity regions to separate the plurality of cavity regions.

### EFFECT OF INVENTION

According to one embodiment of the present disclosure, by removing the housing portion surrounding the side portion of the light emitting surface of at least one light emitting diode chip mounted on the light emitting diode package, the light emitting surface is exposed not only in the upward direction but also in the lateral directions in which the housing portion is removed and the beam angle is enlarged. Accordingly, the concentration of light at the center of the light emitting surface of the light emitting diode chip is reduced and the hot spot problem and the mura phenomenon can be improved.

Further, it is possible to overcome the insufficient light coverage of the backlight unit by adopting the light emitting diode package capable of improving the hot spot problem and the mura phenomenon.

In addition, according to one embodiment of the present disclosure, it is possible to improve the heat dissipation efficiency while reducing the thickness of the backlight unit including the light emitting diode package.

### BRIEF DESCRIPTION OF THE DRAWINGS

FIG. 1 is a top view of a light emitting diode package according to one embodiment of the present disclosure.
FIG. 2 is a cross-sectional view of the light emitting diode package taken along line II-II in FIG. 1.
FIG. 3 is a cross-sectional view of a second specific region of the light emitting diode package taken along line III-III in FIG. 1.
FIG. 4 is a side view of the light emitting diode package shown in FIG. 1.
FIG. 5 is a bottom view of the light emitting diode package shown in FIG. 1.
FIG. 6 is a graph showing light emitting characteristics of the light emitting diode package shown in FIG. 1.
FIG. 7 is a top view of a light emitting diode package according to another embodiment of the present disclosure.
FIG. 8 is a cross-sectional view of a third specific region of the light emitting diode package taken along line XIII-XIII in FIG. 7.
FIGS. 9A to 9C are cross-sectional views illustrating a method of manufacturing a light emitting diode package according to one embodiment of the present disclosure.
FIG. 10 is an exploded perspective view showing a backlight unit according to one embodiment of the present disclosure.
FIG. 11 is an exploded perspective view showing a display device according to one embodiment of the present disclosure.

### BEST MODE FOR CARRYING OUT THE INVENTION

The contents described in the above Background Art section are only for helping to understand the background technology of the technical idea of the present disclosure, and thus may not be understood as the prior art known to those skilled in the art.

In the description below, for the purpose of explanation, many specific details are presented to help understanding of various embodiments. However, it is clear that various embodiments may be implemented without these specific details or in one or more equivalent ways. In other examples, well-known structures and devices are illustrated in a block diagram to avoid making the various embodiments unnecessarily difficult to understand.

In the drawings, the sizes or relative sizes of layers, films, panels, regions, and the like may be exaggerated for clarity. In addition, the same reference numbers represent the same components.

Throughout the specification, when it is expressed that an element or layer is "connected" with another element or layer, the expression includes not only a case in which they are connected directly but also a case in which they are connected indirectly through other element or layer disposed therebetween. However, when it is described that a part is "directly connected to" another part, this will mean that there is no other element between the part and the another part. "At least one of X, Y, and Z" , and "at least any one selected from the group consisting of X, Y, and Z" means one X, one Y, one Z, or any combination of two or more of X, Y, and Z (e.g., XYZ, XYY, YZ, ZZ). Herein, "and/or" includes any combination of one or more of corresponding elements.

Herein, although terms such as first, second, and the like may be used to describe various elements, components, regions, layers, and/or sections, such elements, components, regions, layers, and/or sections are not limited to these terms. These terms are used to distinguish one element, component, region, layer, and/or section from another element, component, region, layer, and/or section. Accordingly, a first element, component, region, layer, and/or section in one embodiment may be referred to as a second element, component, region, layer, and/or section in another embodiment.

Spatially relative terms such as "below", "above", and the like may be used for descriptive purposes, to explain the relationship between one element or feature and another element(s) or feature(s) as shown in the drawings. This is only used to indicate the relationship of one component to another component in the drawings, and does not mean an absolute position. For example, when an apparatus is shown upside down in the drawing, elements depicted as being "below" other elements or features are positioned "above" the other elements or features. Accordingly, in one embodiment, the term "below" may include both up and down. In addition, the apparatus may be otherwise oriented (e.g., rotated 90 degrees or in other orientations), and such spatially relative terms used herein are interpreted accordingly.

The terms used herein are for the purpose of describing specific embodiments and not for the purpose of limitation. Throughout the specification, when a part "includes" a component, it means that other components may be further included, rather than excluding other components. Unless there is another definition, the terms used herein have the same meanings as commonly understood by those of ordinary skill in the art to which the present disclosure pertains.

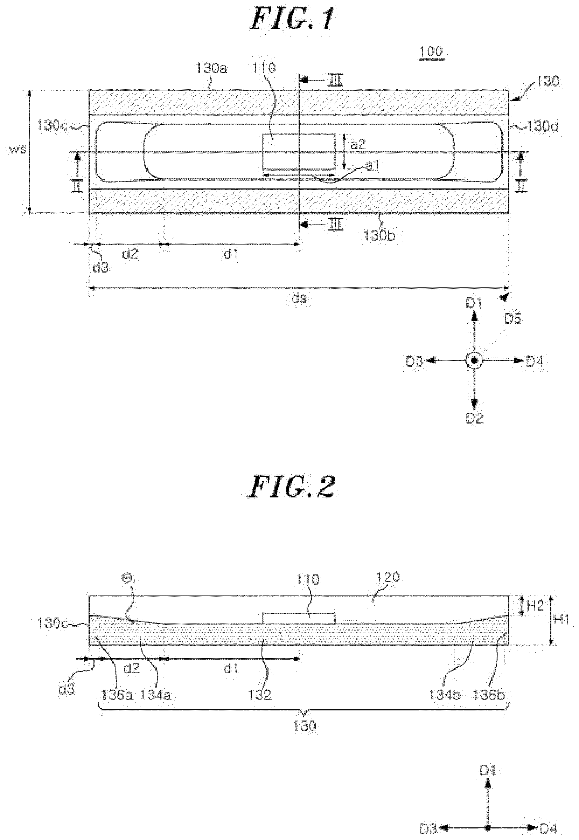

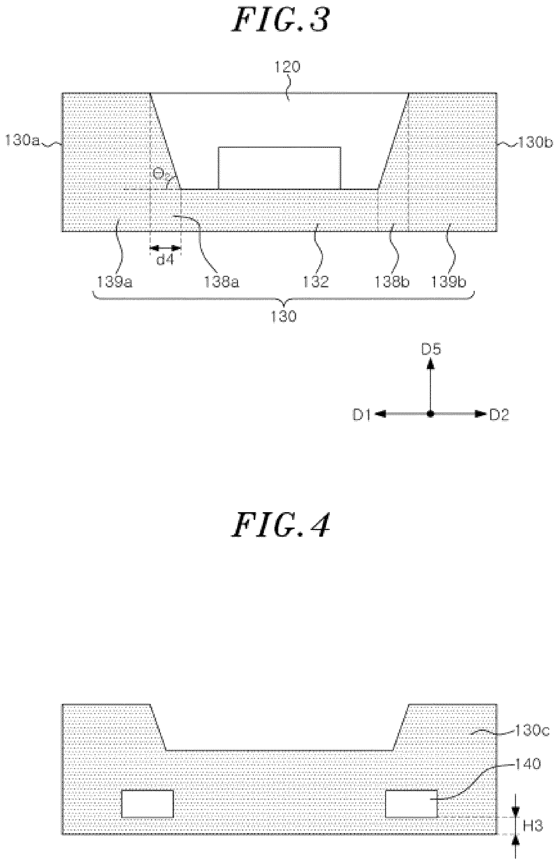

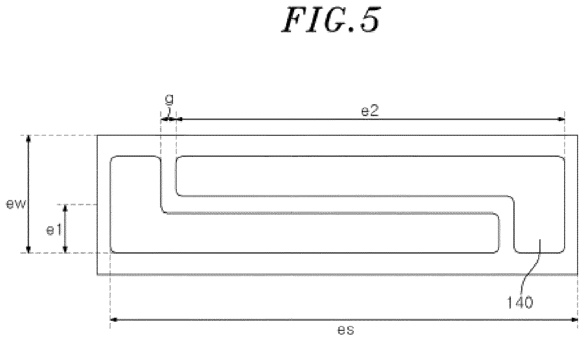

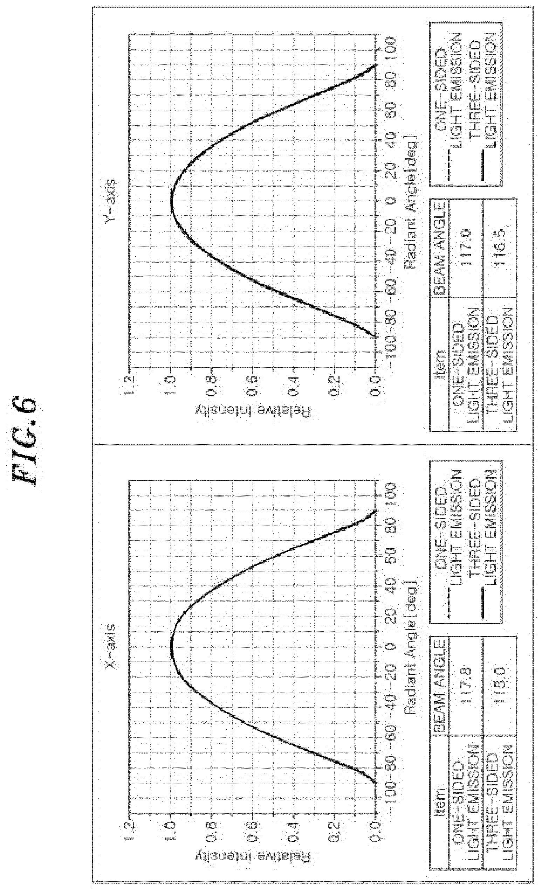

FIG. 1 is a top view of a light emitting diode package according to one embodiment of the present disclosure. Further, FIG. 2 is a cross-sectional view of a first specific region of the light emitting diode package taken along line II-II in FIG. 1, FIG. 3 is a cross-sectional view of a second specific region of the light emitting diode package taken along line III-III in FIG. 1, and FIG. 4 is a side view of the light emitting diode package shown in FIG. 1. FIG. 5 is a bottom view of the light emitting diode package shown in FIG. 1. FIG. 6 is a graph showing light emitting characteristics of the light emitting diode package shown in FIG. 1.

Referring to FIGS. 1 to 4, the light emitting diode package 100 according to the present disclosure may include a light emitting diode chip 110, a resin part 120 formed on the light emitting diode chip 110, and a housing 130 accommodating the light emitting diode chip 110. In this case, the housing 130 may serve as a reflector for reflecting the light emitted through the resin part 120, and for this purpose, the housing 130 may be formed of, for example, silicon or epoxy having a white color, and the like. In addition, referring to FIG. 5, in the light emitting diode package 100 according to the present disclosure, an electrode 140 to be connected to a board, e.g., a printed circuit board (PCB), including a conductive pattern on its lower surface may be exposed.

In the embodiment shown in FIG. 1, one embodiment in which the light emitting diode chip 110 is implemented as a single chip is described, but this is an example and the light emitting diode package 100 is not limited thereto. That is, a plurality of light emitting diode chips 110 may be implemented in a structure in which the light emitting diode chips 100 are arranged in at least one row. The light emitting diode chip 110 may have a full width at half maximum (FWHM) of 30 nm or less. The light emitting diode chip 110 may have a center wavelength between 440 nm and 460 nm. When the light emitting diode chip 110 is implemented as a plurality of light emitting diode chips 110, the center wavelengths of the plurality of light emitting diode chips 110 may be different from each other, and the difference therebetween may be 15 nm or less.

The light emitting diode chip 110 may be implemented as a semiconductor PN junction diode, and the light emitting operation principle of the light emitting diode chip 110 will be briefly described as follows. When a preset voltage is applied to the diode in which the P-type and N-type semiconductors are joined, holes of the P-type semiconductor move to the N-type semiconductor and gather in a middle layer. On the contrary, electrons from the N-type semiconductor move toward the P-type semiconductor and gather into a middle layer, the lowest point of the conduction band. These electrons naturally fall into the holes of the valence band, where they emit as much energy as a difference in height between the conduction band and the valence band, that is, an energy gap, and this energy is emitted in the form of light. Besides, light emitting diode chips of various light emitting methods may be used.

The resin part 120 may be formed to cover a light emitting surface of the light emitting diode chip 110. The resin part 120 includes a light-transmitting material. The resin part 120 may include a transparent resin such as silicon and epoxy, glass, ceramic, or the like. In addition, the resin part 120 may include one or more wavelength conversion materials. The wavelength conversion material converts the wavelength of light emitted from the light emitting diode chip 110 among organic or inorganic wavelength conversion materials and the kind of wavelength conversion material is not limited. The resin part 120 may include a light diffusing material. The light diffusing material diffuses the light emitted from the light emitting diode chip 110, or the wavelength-converted light by the wavelength conversion material, and the kind of light diffusing material is not limited. The resin part 120 may include a light reflecting material. The light reflecting material reflects the light emitted from the light emitting diode chip 110 or the wavelength-converted light by the wavelength conversion material and the kind of light reflecting material is not limited.

When the resin part 120 includes at least one wavelength conversion material, light emitted to the outside through the resin part 120 may be wavelength-converted light by the wavelength converter. For example, when green and red phosphors are included in the wavelength converter of the resin part 120, light emitted to the outside through the resin part 120 may be white light. In this way, the light emitted to the outside through the resin part 120 may implement light in various color gamuts according to the type of the phosphor in the wavelength converter.

The wavelength conversion material may include a phosphor. For example, phosphors emitting light in green wavelength band may include a yttrium-aluminum-garnet-based phosphor (e.g., Y₃(Al, Ga)₅O₁₂:Ce), a lutetium-aluminum-garnet-based phosphor (e.g., Lu₃(Al, Ga)₅O₁₂:Ce), a terbium-aluminum-garnet-based phosphor (e.g., Tb₃(Al, Ga)₅O₁₂:Ce), a silicate-based phosphor (e.g., (Ba, Sr)₂SiO₄:Eu), a chlorosilicate-based phosphor (e.g., Ca₈Mg(SiO₄)₄Cl₂:Eu), a β-sialon-based phosphor (e.g., Si_{6-z}Al_{z}O_{z}N_{8-z}:Eu (0<z<4.2)), an SGS-based phosphor (e.g., SrGa₂S₄:Eu), and the like. Further, phosphors of yellow light may include an α-sialon-based phosphor (e.g., M_{z}(Si, Al)₁₂(O, N)₁₆ (where 0<z≤2, and M is a lanthanide excluding Li, Mg, Ca, Y, La and Ce).

In addition, the phosphors emitting light in the green wavelength band include phosphors emitting light in the yellow wavelength band. Further, for example, the yttrium-aluminum-garnet-based phosphor is able to emit light in a yellow wavelength region by substituting a part of Y with Gd and shifting the emission peak wavelength toward a longer wavelength. Furthermore, the phosphors emitting light in the green wavelength band include phosphors capable of emitting light in the main yellow wavelength band.

The phosphors emitting light in the red wavelength band may include a nitrogen-containing alumino silicon calcium (CASN or SCASN)-based phosphor (e.g., (Sr, Ca)AlSiN₃:Eu). In addition, there is a manganese-activated fluoride-based phosphor (a phosphor represented by general formula (I) of A₂[M₁₋ₐMnₐF₆] where A is at least one selected from the group consisting of K, Li, Na, Rb, Cs, and NH₄, M is at least one element selected from a group consisting of group 4 elements and group 14 elements, and a satisfies 0<a<0.2). A representative example of the manganese-activated fluoride-based phosphor is a phosphor of manganese-activated potassium silicon fluoride (e.g., K₂SiF₆:Mn). In addition, there is a manganese-activated phosphor (a phosphor represented by general formula (II) (A₄₋ₐBₐ)_{m/2+n/2}X₂ₘ[MX₄O₂]ₙ) based on an oxidohalide host lattice). However, in the general formula (II), A is hydrogen (H) and/or deuterium (D), B is Li, Na, K, Rb, Cs, NH4, ND4, and/or NR4, wherein R is an alkyl or aryl radical, X is F and/or Cl, M is Cr, Mo, W and/or Re, and 0 ≤ a ≤ 4, 0 ≤ m ≤ 10, and 1 ≤ n ≤ 10.

In addition, the housing 130 is formed to surround at least one side of the resin part 120, and may perform an operation of reflecting the light emitted from the light emitting diode chip 110. For example, as mentioned above, the housing 130 may be formed of a white silicon or epoxy, and the like. However, the configuration of the housing 130 according to the present disclosure is not necessarily limited thereto. That is, as another embodiment, the housing 130 may be formed of at least one of silver (Ag) and aluminum (Al) as a material that reflects light and does not transmit light even though a portion of light is absorbed. The housing 130 made of silver has high light reflectivity. In addition, the housing 130 made of aluminum has high adhesion to the resin part 120. As such, based on reflectivity or adhesion, the housing 130 may be formed as one layer made of silver or aluminum. Alternatively, by forming the housing 130 in a multi-layered structure of aluminum-silver-aluminum layers, both adhesion and reflectivity may be improved. Although not shown in the drawings, at least one layer made of nickel (Ni) and titanium (Ti) may be further disposed on the housing 130. In addition, the material of the housing 130 is not limited to aluminum and silver, and anything capable of reflecting light emitted from the light emitting diode chip 110 may be used.

Referring to FIGS. 1 to 3, in a width direction of the housing 130, directions toward one side and the other side in the width direction of the housing 130 may respectively be defined as a first direction D1 and a second direction D2, and in a longitudinal direction of the housing 130, directions toward one side and the other side in the longitudinal direction of the housing 130 may respectively be defined as a third direction D3 and a fourth direction D4. The housing 130 has a first surface 130a perpendicular to the first direction D1, a second surface 130b perpendicular to the second direction D2, a third surface 130c perpendicular to the third direction D3 and a fourth surface 140d perpendicular to the fourth direction D4. According to the embodiment shown in FIG. 1, the first surface 130a and the second surface 130b may be formed to be longer than the third surface 130c and the fourth surface 130d, but the present disclosure is not limited thereto. That is, the lengths of the first to fourth surfaces may be the same. For example, a ratio of a width ws of the housing 130 to a length ds of the housing 130 may be 1 to 11 to 1 to 1, and specifically, the length ds of the housing 130 and the width ws of the housing 130 may be 7 mm and 2 mm, respectively. In addition, the light emitting diode chip 110 and the resin part 120 may be mounted in an upward direction D5 with respect to the plane of the housing 130, and the length and width of the light emitting diode chip 110 may be formed in consideration of the light emitting area of the housing and light efficiency. For example, a length a1 and a width a2 of the light emitting diode chip 110 may be formed to be 0.5 to 0.8 mm and 0.4 to 0.8 mm, respectively.

As shown in FIGS. 1 to 4, the housing 130 according to the embodiment of the present disclosure has a structure in which the first surface 130a and the second surface 130b surround the resin part 120 formed inside the housing 130, but the third surface 130c and the fourth surface 130d are cut so that at least a portion of the resin part 120 is exposed. Through such a structure, the light emitting surface of the light emitting diode package 100 is exposed not only in the upward direction D5 but also in the lateral directions D3 and D4 in which the housing portion is removed, and the beam angle of light is enlarged. Accordingly, the concentration of light at the center of the light emitting surface of the light emitting diode chip is reduced and the hot spot problem and the mura phenomenon can be improved.

FIG. 2 is a cross-sectional view of the light emitting diode package 100 taken along II-II line in FIG. 1 and shows a cross-sectional view with respect to a first specific region in the third direction D3 and the fourth direction D4 of the light emitting diode package 100 shown in FIG. 1. As shown in FIG. 2, a structure is shown in which the third surface 130c and the fourth surface 130d of the housing 130 are cut to expose the resin part 120.

Meanwhile, FIG. 3 is a cross-sectional view of the light emitting diode package 100 taken along line III-III in FIG. 1, and shows a cross-sectional view with respect to a second specific region in the first direction D1 and the second direction D2 of the light emitting diode package 100. As shown in FIG. 3, the first surface 130a and the second surface 130b of the housing 130 have a structure surrounding the resin part 120 formed inside the housing 130. That is, the resin part 120 is not exposed in the first direction D1 and the second direction D2.

Referring to FIGS. 2 and 3, according to the structure of the housing 130 according to the embodiment of the present disclosure, a height of the housing 130 with respect to the surfaces through which the resin part 120 is exposed (i.e., the third surface 130c and the fourth surface 130d) and a height of the housing 130 with respect to the adjacent surfaces (i.e., the first surface 130a and the second surface 130b) are set to be different to adjust the light beam angle. The structure of the housing 130 will be described in more detail as follows.

Referring to FIG. 2, the housing 130 may include a mounting portion 132 on which the light emitting diode chip 110 is mounted, a third sidewall portion 134a and a fourth sidewall portion 134b respectively extending from the mounting portion 132 in the third direction D3 and the fourth direction D4, a third step portion 136a extending from the third sidewall portion 134a to the third surface 130c, and a fourth step portion 136b extending from the fourth sidewall portion 134b to the fourth surface 130d.

In addition, referring to FIG. 3, the housing 130 may include the mounting portion 132 on which the light emitting diode chip 110 is mounted, a first sidewall portion 138a and a second sidewall portion 138b respectively extending from the mounting portion 132 in the first direction D1 and the second direction D2, a first step portion 139a extending from the first sidewall portion 138a to the first surface 130a, and a second step portion 139b extending from the second sidewall portion 138b to the second surface 130b.

A concave region formed by the mounting portion 132 and the first to fourth sidewall portions 138a, 138b, 134a and 134b may be defined as a cavity, the light emitting diode chip 110 may be mounted in the cavity, and the resin part 120 formed on the upper portion of the light emitting diode chip 110 may fill the cavity.

FIG. 4 illustrates a side surface of the light emitting diode package 100 in the third direction D3 illustrated in FIG. 1, that is, the third surface 130c of the housing 130.

As shown in FIGS. 2 and 4, when the housing 130 according to the embodiment of the present disclosure is viewed from the third surface 130c and the fourth surface 130d of the housing 130, the side surfaces of the resin part 120 are partially exposed, and light emitted from the light emitting diode chip 110 may be emitted through the exposed region of the resin part 120.

Further, as shown in FIG. 4, in the case of the embodiment of the present disclosure, when the housing 130 is viewed from the third surface 130c and the fourth surface 130d of the housing 130, electrodes 140 electrically connected to the light emitting diode chip 110 are exposed on the third surface 130c and the fourth surface 130d of the housing 130, and the electrodes 140 may be formed in a form surrounded by the housing 130. That is, referring to FIG. 4, the electrodes 140 exposed to the third surface 130c and the fourth surface 130d are formed at positions spaced apart from a bottom surface of the housing 130 by a predetermined height H3, and may be implemented in a form surrounded by the housing 130. Accordingly, the electrodes 140 exposed on the third surface 130c and the fourth surface 130d do not directly contact a circuit board (not shown) attached to the bottom surface of the housing 130, so that short circuit occurring due to static electricity can be prevented.

In addition, in case of a structure in which the electrodes 140 contact the circuit board on the third and fourth surfaces 130c and 130d of the housing 130, light emitted from the adjacent light emitting diode chip 110 may be reflected from the third surface 130c and the fourth surface 130d, the corner regions of the housing 130, which may reduce light efficiency. However, the present disclosure may overcome such a problem of the reduction of light efficiency by disposing the electrodes 140 at positions spaced apart by the predetermined height H3 from the bottom surface of the housing 130.

Furthermore, as shown in FIG. 4, when viewed from the direction of the third surface 130c, the electrode 140, the housing 130, and the resin part 120 may be exposed, but the light emitting diode chip 110 may not be exposed by the third surface 130c of the housing 130. That is, when viewed from the third surface 130c and the fourth surface 130d of the housing 130, the lower surface of the resin part 120 is formed higher than the light emitting diode chip 110 to prevent direct side emission of light emitted from the light emitting diode chip 110. Accordingly, it is possible to suppress the occurrence of excessively bright spots between adjacent light emitting diode chips. Referring back to FIG. 2, a height H2 of the exposed region where the resin part 120 is exposed through the third surface 130c and the fourth surface 130d of the housing 130 may be set to be about 50% or less of an overall height H1 of the light emitting diode package 100. Further, a difference between the overall height H1 of the light emitting diode package 100 and the height H2 of the exposed region may be set to be greater than a thickness of the light emitting diode chip 110. For example, H1 and H2 may be 0.6 to 0.8 mm and 0.15 to 0.3 mm, respectively. As the height H2 of the exposed region increases, that is, as the height of the third step portion 136a and the fourth step portion 136b respectively constituting the third surface 130c and the fourth surface 130d of the housing 130 decreases, the height of light emitted through the exposed side surface decreases, which may cause a problem in which the light reaches the side exposure electrode 140 formed in an adjacent light emitting diode package and is absorbed by the side exposure electrode 140.

Moreover, referring to FIG. 5, in the light emitting diode package 100 according to the embodiment of the present disclosure, the electrode 140 to be connected to the PCB may be exposed through the bottom surface of the light emitting diode package 100. The electrode 140 exposed through the bottom surface may have a substantially rectangular shape in which a pair of electrodes having an approximately "L" shape are disposed with a gap g therebetween. For example, a rectangle formed by the pair of electrodes may have an overall length es and an overall width ew of 6 to 6.65 mm and 1 to 1.4 mm, respectively. In addition, the gap g crossing the inside of the rectangular shape may be 0.18 to 0.25 mm. The "L"-shaped electrode 140 may have a short-side length e1 and a long-side length e2 of 1 to 1.5 mm and 5 to 5.8 mm, respectively, and a part of the gap g may extend along the extension direction of the long side of the electrode 140 in a portion spaced apart by 0.2 to 0.8 mm from the long side of the electrode 140 in the width direction.

The mounting portion 132 of the housing 130 is implemented as a flat surface at the center of the cavity so as to mount the light emitting diode chip 110 as shown in FIGS. 2 and 3.

As shown in FIG. 2, the third sidewall portion 134a and the fourth sidewall portion 134b of the housing 130 are implemented as inclined surfaces having a first inclination angle θ1 while extending in the third direction D3 and the fourth direction D4 from the mounting portion 132, respectively. In addition, as shown in FIG. 3, the first sidewall portion 138a and the second sidewall portion 138b of the housing 130 are implemented as inclined surfaces having a second inclination angle θ2 while extending in the first direction D1 and the second direction D2 from the mounting portion 132, respectively.

As described above, the cavity may be formed by the mounting portion 132 and the first to fourth sidewall portions 134a, 134b, 138a, and 138b of the housing 130. Accordingly, the resin part 120 formed inside the cavity may be implemented in a form in which the inner surface is depressed downward by the sidewall portions implemented as the inclined surfaces. As shown in the drawings, as the resin part 120 is implemented in a downward convex shape, a part of the light emitted from the light emitting diode chip 110 is refracted into the resin part 120. Accordingly, light may be emitted more efficiently through the side surfaces exposed in the third and fourth directions D3 and D4, that is, to the exposed region of the resin part 120.

In addition, in the case of the embodiment of the present disclosure, the first inclination angle θ1 of the third sidewall portion 134a and the fourth sidewall portion 134b has a value smaller than the second inclination angle θ2 of the first sidewall portion 138a and the second sidewall portion 138b. That is, the third sidewall portion 134a and the fourth sidewall portion 134b extending to the side surfaces exposed in the third and fourth directions D3 and D4 are respectively implemented as inclined surfaces having gentler slopes than the first sidewall portion 138a and the second sidewall portion 138b having no exposed side surfaces, and thus light may be more efficiently emitted through the exposed region of the resin part 120.

However, the embodiment in which the first to fourth sidewall portions 134a, 134b, 138a, and 138b have the inclined surfaces is an example, and the structure of the housing 130 of the present disclosure is not limited thereto. For example, the first to fourth sidewall portions 134a, 134b, 138a, and 138b may have curved surfaces.

Referring to FIG. 2, with reference to the region where the light emitting diode chip 110 is mounted, when a distance from the center of the mounting portion 132 of the light emitting diode chip 110 to a first boundary between the mounting portion 132 and the third sidewall portion 134a is a first distance d1, a distance from the first boundary to a second boundary between the third sidewall portion 134a and the third step portion 136a is a second distance d2, and a distance from the second boundary to a boundary between the third step portion 136a and the third surface 130c of the housing is a third distance d3, the first to third distances d1, d2, and d3 may have a distance relationship of d1 > d2 > d3. Here, d1 may be formed to be approximately 2 to 5 times greater than the sum of d2 and d3. For example, d1, d2, and d3 may be formed of 2 to 2.54 mm, 0.7 to 0.86 mm, and 0.05 to 0.2 mm, respectively. That is, by making the first distance d1 sufficiently larger than the other second and third distances d2 and d3, light emitted from the light emitting diode chip 110 can be guided to the side surfaces (e.g., the third surface 130c) of the housing as much as possible.

In addition, referring to FIG. 3, when a distance from the first sidewall portion 138a to the first step portion 139a is a fourth distance d4, the fourth distance d4 may be smaller than the second distance d2 from the third sidewall portion 134a to the third step portion 136a shown in FIG. 2. This is because, as described above, the first inclination angle θ1 of the third sidewall portion 134a and the fourth sidewall portion 134b has a value smaller than the second inclination angle θ2 of the first sidewall portion 138a and the second sidewall portion 138b.

Further, referring to FIG. 3, an upper surface of the first step portion 139a extending from the first sidewall portion 138a to the first surface 130a, and an upper surface of the second step portion 139b extending from the second sidewall portion 138b to the second surface 130b may be formed to have the same height as an upper surface of the resin part 120 as illustrated. Accordingly, in case that the light emitted from the light emitting diode chip 110 re-enters and reaches an outer periphery of the housing 130, re-entering into the cavity may be reduced, which increases light emission efficiency.

That is, in the light emitting diode package shown in FIGS. 1 to 4, by removing the portion of the housing 130 surrounding the side of the light emitting surface of the light emitting diode chip 110, the light emitting surface is implemented not with one-sided light emission only in the upward direction, but with three-sided light emission through the third surface 130c and the fourth surface 130d of the housing 130 as well as in the upward direction. Accordingly, the beam angle of light emitted from the light emitting diode chip 110 is enlarged

FIG. 6 is a graph showing light emitting characteristics of the light emitting diode package shown in FIG. 1, and shows comparison of the light emission characteristics of the three-sided light emitting diode package according to the embodiment of the present disclosure with the light emission characteristics of a conventional one-sided light emitting diode package.

Referring to FIG. 6, in the case of the conventional one-sided light emitting diode package, the beam angle in the x-axis direction is 117.8 degrees, and the beam angle in the y-axis direction is only 0.8 degrees, so the difference in the beam angle in the x-axis and y-axis directions is only 0.8 degrees.

On the other hand, in the case of the three-sided light emitting diode package according to the embodiment of the present disclosure, the beam angle in the x-axis direction is 118.0 degrees and the beam angle in the y-axis direction is 116.5 degrees, so the difference in the beam angle in the x-axis and y-axis directions is enlarged to 1.5 degrees. By enlarging the emission beam angle in this way, the light concentration at the center of the emission surface of the light emitting diode chip can be reduced to improve the hot spot problem and the mura phenomenon. The light emitting diode package 100 illustrated in FIGS. 1 to 4 shows an example in which one light emitting diode chip 110 is mounted in the cavity, but the light emitting diode package according to the embodiment of the present disclosure is not limited thereto.

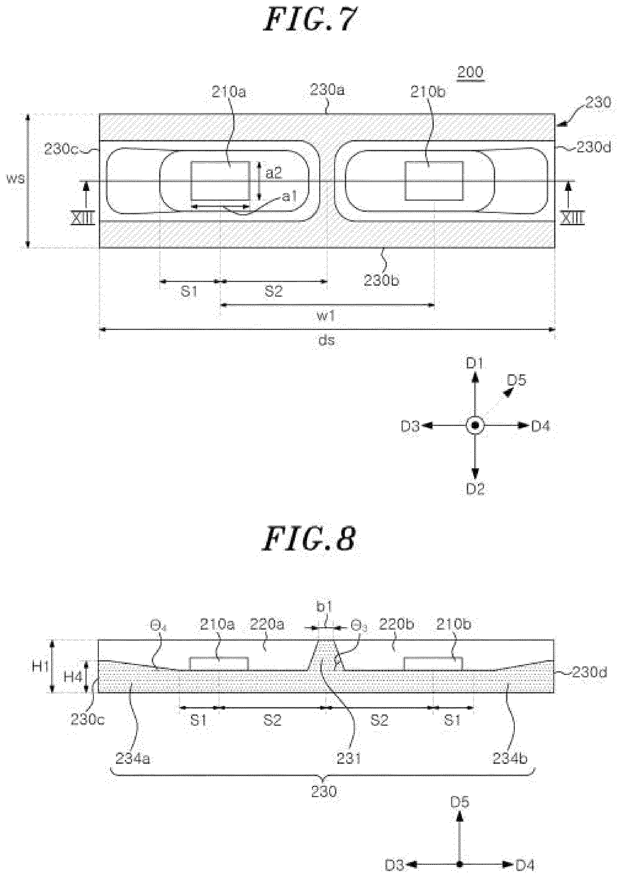

That is, the light emitting diode package may mount a plurality of light emitting diode chips, and FIGS. 7 and 8 describe one embodiment in which two light emitting diode chips 210a and 210b are mounted.

FIG. 7 is a top view of a light emitting diode package 200 according to another embodiment of the present disclosure, and FIG. 8 is a cross-sectional view of a third specific region of the light emitting diode package taken along line XIII-XIII in FIG. 7.

As mentioned above, the light emitting diode package 200 shown in FIGS. 7 and 8 has a difference, when compared with the light emitting diode package 100 shown in FIGS. 1 to 5, in that a plurality of light emitting diode chips 210a, 210b is mounted instead of the single light emitting diode chip 110. Accordingly, although a housing 230 of the light emitting diode package 200 is illustrated as having cavities corresponding to the number of light emitting diode chips, the plurality of light emitting diode chips may be mounted in one cavity. However, basic configurations and materials of the light emitting diode chips 210a and 210b, resin parts 220a and 220b, and the housing 230 constituting the light emitting diode package 200 may be substantially the same as those of the embodiment illustrated in FIGS. 1 to 5.

Referring to FIGS. 7 and 8, one embodiment in which two light emitting diode chips 210a and 210b are mounted in the light emitting diode package 200 is described, and the housing 230 includes two cavities. In this case, as illustrated in FIG. 7, the housing 230 may include a partition wall 231 formed between the cavities to distinguish the two cavities.

That is, first and second light emitting diode chips 210a and 210b are mounted in the two cavities, respectively, and first and second resin parts 220a and 220b are formed on the light emitting diode chips 210a and 210b, respectively.

In addition, as the embodiment illustrated in FIGS. 1 to 4, the housing 230 has a first surface 230a in the first direction D1, a second surface 230b in the second direction D2 opposite to the first surface, and a third surface 230c in the third direction D3 perpendicular to the first direction and a fourth surface 240d in the fourth direction D4 opposite to the third surface.

That is, the housing 230 according to the embodiment of the present disclosure, as shown in FIGS. 7 and 8, has a structure in which the first surface 230a and the second surface 230b surround the first and second resin parts 220a and 220b formed inside the housing 230, but the third surface 230c and the fourth surface 230d are cut so that the side surfaces of the first and second resin parts 220a and 220b are exposed. Through such a structure, the light emitting surfaces of the first and second light emitting diode chips 210a and 210b are exposed not only in the upward direction D5 but also in the lateral directions D3 and D4 of the side portions from which the housing portion is removed, so that the beam angle is enlarged. Accordingly, the concentration of light at the center of the light emitting surface of the light emitting diode chip is reduced and the hot spot problem and the mura phenomenon can be improved.

More specifically, as shown in FIGS. 7 and 8, the first light emitting diode chip 210a and the first resin part 220a are exposed in the third direction D3 in which the housing is removed, and the second light emitting diode chip 210b and the second resin part 220b may be exposed in the fourth direction D4 in which the housing is removed. That is, the side exposure directions of the first light emitting diode chip 210a and the second light emitting diode chip 210b may be formed in opposite directions, and may have a symmetrical shape with respect to the partition wall 231 between the first light emitting diode chip 210a and the second light emitting diode chip 210b, which is effective for uniform light emission on both sides. In this case, a side surface of the partition wall 231 separating the cavities may have a preset inclined surface having a third inclination angle θ3 as illustrated in FIG. 8, and due to the third inclination angle θ3, a length b1 of an upper end of the partition wall 231 may be formed to be approximately 5% to 6% or less of the total length ds of the housing. For example, in the housing 230 having a total length ds of 7 mm, the length b1 of the upper end of the side wall 231 may be formed to be 0.38 mm. In addition, the third inclination angle θ3 that is the slope of the inclination surface of the partition wall 231 may be greater than the fourth inclination angle θ4, which is the slope of the third and fourth sidewall portion 234a and 234b of the housing 230.

In addition, referring to FIG. 8, based on a bottom surface of the housing 230, a height H1 of the partition wall 231 may be greater than a height H2 of the third and fourth sidewall portions 234a and 234b. For example, H2 may have a size of 50-70% of H1, and H1 and H2 may be 0.75 mm and 0.47 mm, respectively.

At least one light emitting diode chip 210a and 210b may be disposed in each of the two cavity regions separated by the partition wall 231. The first light emitting diode chip 210a and the second light emitting diode chip 210b mounted in the respective cavity regions may have different central wavelengths. In addition, the first and second light emitting diode chips may have central wavelengths in different color bands.

The two cavity regions separated by the partition wall 231 may emit light at different color temperatures or different wavelengths, which may be implemented when the first and second light emitting diode chips 210a and 210b mounted in the respective cavity regions emit light of different wavelengths, or the first and second resin parts 220a and 220b are formed of different materials. For example, the first resin part 220a may be formed of a transparent resin, and the second resin part 220b may include at least one wavelength conversion material.

When the first resin part is formed of a transparent resin, the light emitted to the outside through the first resin part may be the primary light emitted from the first light emitting diode chip 210a. When the second resin part includes at least one wavelength conversion material, the second resin part includes a wavelength converter for converting a wavelength of the primary light emitted from the second light emitting diode chip 220b, and the light emitted to the outside through the second resin part may be wavelength-converted light by the wavelength converter. For example, when green and red phosphors are included in the wavelength converter of the second resin part, light emitted to the outside through the second resin part may be white light. In this way, the light emitted to the outside through the second resin part may be light in various color bands depending on the type of the phosphor of the wavelength converter.

Signals having different current values may be applied to the first and second light emitting diode chips 210a and 210b mounted in the respective cavities, and due to the change in the current value, various color temperature adjustments according to the field of application may be made.

In addition, referring to FIGS. 7 and 8, the first and second light emitting diode chips 210a and 210b may be respectively mounted on inner bottom surfaces of the two separated cavity regions, and when it is assumed that the first and second directions D1 and D2 are up-down directions and the third and fourth directions D3 and D4 are left-right directions, the first and second light emitting diode chips 210a and 210b may be disposed at the center in the up-down directions, that is, the first and second directions D1 and D2. Further, when viewed based on the left-right directions, that is, the third and fourth directions D3 and D4, the first and second light emitting diode chips 210a and 210b may respectively be disposed close to the third and fourth sidewall portions 134a and 134b at the center in each cavity.

More specifically, when a distance from the center of the mounting region of the first light emitting diode chip 210a to one end of the third sidewall portion 234a adjacent to the first light emitting diode chip 210a is a first distance S1, and a distance from the center of the mounting region of the first light emitting diode chip 210a to the center of the partition wall 231 is a second distance S2, the first distance S1 is smaller than the second distance S2 as illustrated.

Similarly, when a distance from the center of the mounting region of the second light emitting diode chip 210b to one end of the fourth sidewall portion 234b adjacent to the second light emitting diode chip 210b is the first distance S1, and a distance from the center of the mounting region of the second light emitting diode chip 210b to the center of the partition wall 231 is the second distance S2, the first distance S1 is smaller than the second distance S2 as illustrated. For example, S1 may be approximately 40% or less of S2, and S1 and S2 may be 0.4 to 0.5 mm and 1 to 2 mm, respectively. In addition, S2 may be 1/4 of the length ds of the housing 230.

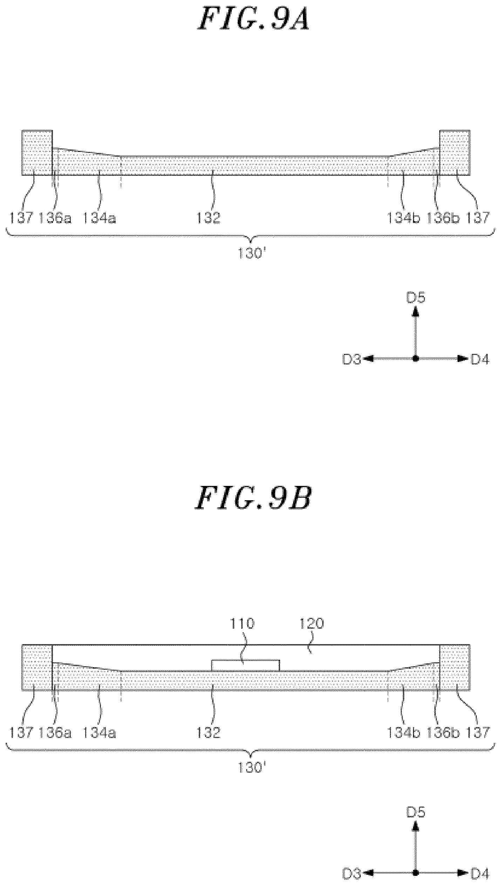

Accordingly, the first and second light emitting diode chips 210a and 210b may be disposed symmetrical in the up-down directions but asymmetrically in the left-right directions, with respect to the inner lower surfaces in the respective cavities. As described above, by disposing the respective light emitting diode chips 210a and 210b close to the third and fourth sidewalls 134a and 134b with a gentle slope, the light may be guided to be evenly distributed in the lateral directions (e.g., the third and fourth directions D3 and D4). FIGS. 9A to 9C are cross-sectional views illustrating a method of manufacturing a light emitting diode package according to one embodiment of the present disclosure.

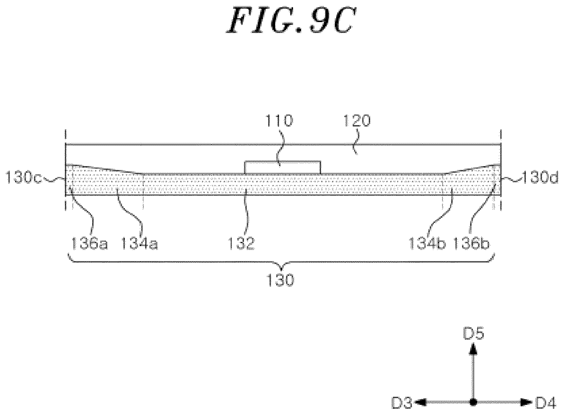

The embodiment shown in FIGS. 9A to 9C is described based on cross-sectional views of a first specific region in the third direction D3 and the fourth direction D4 of the light emitting diode package shown in FIG. 2, and thus, the embodiment shown in FIG. 9C is substantially the same as the cross-sectional view of the light emitting diode package shown in FIG. 2.

Referring to FIG. 9A, first, a housing mold 130' having a cavity for mounting the light emitting diode chip 110 is formed.

The housing mold 130' may include the mounting portion 132 on which the light emitting diode chip 110 is mounted, the third sidewall portion 134a and the fourth sidewall portion 134b extending from the mounting portion 132 respectively in the third and fourth directions D3 and D4, the third step portion 136a extending from the third sidewall portion 134a to the third surface 130c, and the fourth step portion 136b extending from the fourth sidewall portion 134b to the fourth surface 130d, and an outer wall part 137 formed on the outside of the third and fourth step portions 136a and 136b.

In addition, a cross-sectional view of a second specific region in the first direction D1 and the second direction D2 of the housing mold 130' is substantially the same as the cross-sectional view illustrated in FIG. 3. Accordingly, referring to FIG. 3, the housing mold 130' includes the first sidewall portion 138a and the second sidewall portion 138b extending respectively in the first and second directions D1 and D2 from the mounting portion 132, the first step portion 139a extending from the first sidewall portion 138a to the first surface 130a, and the second step portion 138b extending from the second sidewall portion 138b to the second surface 130b.

Then, as illustrated in FIG. 9B, the light emitting diode chip 110 may be mounted in a cavity formed by the mounting portion 132 and the first to fourth sidewall portions 138a, 138b, 134a, and 134b, and the resin part 120 formed on the light emitting diode chip 110 may fill the inside of the cavity.

In this case, since the outer wall part 137 of the housing mold 130' has a structure surrounding the resin part 120 in the same manner as the first and second step portions 139a and 139b shown in FIG. 3, the resin part 120 is not exposed in the third and fourth directions D3 and D4 as well as in the first and second directions D1 and D2.

Thereafter, as shown in FIG. 9C, as the outer wall part 137 of the housing mold 130' is cut and removed, the housing 130 identical to that in the embodiment shown in FIG. 2 may be formed. That is, the third surface 130c and the fourth surface 130d of the housing 130 are cut to form a structure in which the resin part 120 is exposed.

The housing 130 according to the embodiment of the present disclosure is implemented in a structure in which the resin part 120 formed inside the housing 130 is surrounded in the first direction D1 and the second direction D2, but the third surface 130c and the fourth surface 130d are cut to expose the resin part 120 and enlarge the beam angle. Accordingly, the concentration of light at the center of the light emitting surface of the light emitting diode chip 110 is reduced and the hot spot problem and the mura phenomenon can be improved.

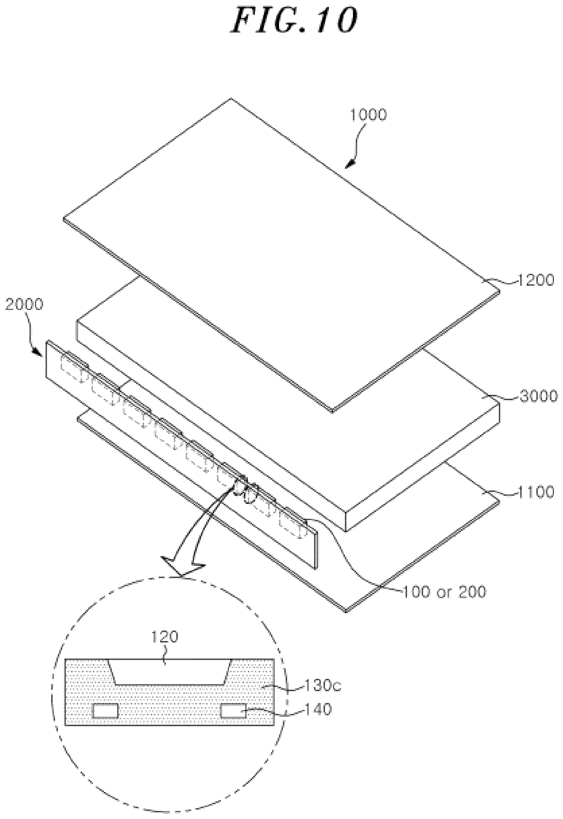

FIG. 10 is an exploded perspective view showing a backlight unit according to one embodiment of the present disclosure.

Referring to Fig. 10, the backlight unit 1000 according to the embodiment of this disclosure may include the light emitting diode packages 100 according to the embodiment illustrated in Figs. 1 to 5 or the light emitting diode packages 200 according to the embodiments illustrated in FIGS. 7 and 8, and a light guide plate 3000.

More specifically, the light emitting diode packages 100 or 200 have a feature in which by removing the housing portion surrounding both sides of the light emitting surface of the light emitting diode chip, so that the emission surface is implemented as three-sided emission in which light is emitted also in the lateral directions in which the housing is removed, that is, through both sides of the housing instead of one-sided emission in which light is emitted only in then upward direction.

Referring to the enlarged cross-sectional view of the side of the light emitting diode packages 100 or 200, as shown in FIG. 10, the side surface 130c of the housing 130 through which the resin part 120 is exposed is shown. Accordingly, the side surfaces of the adjacent light emitting diode packages 100 or 200 may be arranged in such a way that the exposed sides of the resin parts 120 face each other. The light emitting diode packages 100 or 200 are disposed on one side of the light guide plate 3000 to supply light to the light guide plate 3000. The light emitting diode packages 100 or 200 may be mounted on one surface of a circuit board 2000. The circuit board 2000 is for fixing the light emitting diode packages 100 or 200 and applying electric power to the light emitting diode packages 100 or 200, and is disposed on one side of the light guide plate 3000. The circuit board 2000 may be formed of, for example, a printed circuit board (PCB) or a flexible printed circuit board (FPCB). The circuit board 2000 may be disposed at a central portion of the light guide plate 3000 in the thickness direction of the light guide plate 3000.

The light guide plate 3000 changes the path of the light incident from the light emitting diode packages 100 or 200 disposed on the side thereof and guides the light toward a display panel to be disposed thereon. The light guide plate 3000 is preferably formed of a transparent material to minimize light loss. The light guide plate 3000 may be formed of a material such as a transparent polymethyl methacrylate (PMMA) or polycarbonate (PC).

Meanwhile, the backlight unit 1000 may further include a reflective sheet 1100 disposed on a lower surface of the light guide plate 3000. The reflective sheet 1100 reflects the light leaking through the lower surface of the light guide plate 3000 to the inside of the light guide plate 3000 to improve light use efficiency. The reflective sheet 1100 is formed of, for example, a white polyethylene terephthalate (PET) or polycarbonate (PC) material. In addition, the backlight unit 1000 may further include at least one optical sheet 1200 disposed on the light guide plate 3000. The optical sheet 1200 includes at least one of a diffusion sheet for diffusing light to improve luminance uniformity, a light collecting sheet for collecting light to improve front luminance, a reflective polarizing sheet for increasing luminance through recycling of light, and the like.

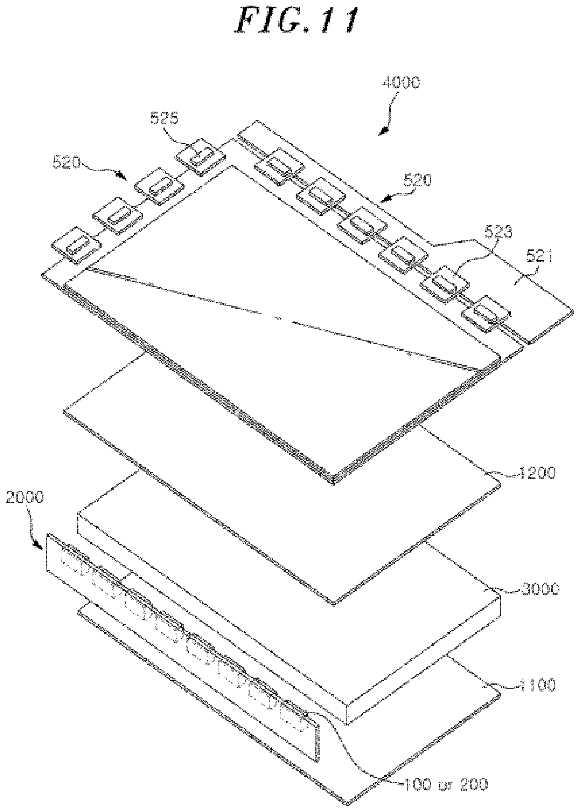

FIG. 11 is an exploded perspective view showing a display device according to one embodiment of the present disclosure.

Referring to FIG. 11, a display device 4000 according to one embodiment of the present disclosure includes a display unit 500 for displaying an image and a backlight unit 1000 for supplying light to the display unit 500. Since the backlight unit 1000 has already been described with reference to FIG. 9, a redundant description related thereto will be omitted. The display unit 500 includes a display panel 510 for substantially displaying an image and a driving circuit unit 520 for driving the display panel 510. The display panel 510 may include a first substrate 512, a second substrate 514 coupled to the first substrate 512 to face each other, and a liquid crystal layer (not shown) interposed between the first substrate 512 and the second substrate 514.

The first substrate 512 is a thin film transistor (TFT) substrate in which TFTs, which are switching elements, are formed in a matrix form. A data line and a gate line are respectively connected to a source terminal and a gate terminal of each TFT, and a pixel electrode made of a transparent conductive material is connected to a drain terminal. The second substrate 514 is a color filter substrate on which a RGB color filter for realizing colors is formed in a thin film form. A common electrode made of a transparent conductive material is formed on the second substrate 514.

Meanwhile, the RGB color filter may be formed on the first substrate 512. In the display panel 510, when a gate driving signal is applied to the gate terminal of the TFT and the TFT is turned on, a data signal is applied to the pixel electrode to form an electric field between the pixel electrode and the common electrode. The arrangement of liquid crystal molecules in the liquid crystal layer disposed between the first substrate 512 and the second substrate 514 is changed by the electric field, and the transmittance of light supplied from the backlight unit 100 is changed according to the change in arrangement of the liquid crystal molecules, which allows an image of a desired gradation to be displayed.

The driving circuit unit 520 may include a source printed circuit board 521 that outputs various control signals for driving the display panel 510, a data driving circuit film 523 that connects the source printed circuit board 521 and the display panel 510, and a gate driving circuit film 525 connected to the display panel 510. The data driving circuit film 523 is connected to the data line of the first substrate 512, and the gate driving circuit film 525 is connected to the gate line of the first substrate 512. The data driving circuit film 523 and the gate driving circuit film 525 may respectively include a data driving chip and a gate driving chip that output a driving signal for driving the display panel 510 in response to a control signal supplied from the source printed circuit board 521. The data driving circuit film 523 and the gate driving circuit film 525 are made of, for example, a tape carrier package (TCP) or a chip on film (COF). Although not shown, the driving circuit unit 520 may further include a gate printed circuit board connected to the gate driving circuit film 525. In addition, the gate driving circuit film 525 may be removed by directly mounting the gate driving chip on the first substrate 512 or directly forming the gate driving circuit on the first substrate 512 through a thin film process.

As described above, in the present disclosure, specific matters such as specific components, etc., and limited embodiments and drawings have been described, but these are only provided to help a more general understanding of the present disclosure. The present disclosure is not limited to the above embodiments, and various changes and modifications may be made from these descriptions by those skilled in the art to which the present disclosure pertains.

Accordingly, the spirit of the present disclosure should not be limited to the described embodiments, and it should be construed that not only the claims described below, but also equivalents to the claims and equivalent modifications to the claims are within the scope of the spirit of the present disclosure.

## Claims

1. A light emitting diode package comprising:
a housing including a cavity region therein;
a light emitting diode chip mounted on one surface in the cavity of the housing; and
a resin part formed in the cavity region to cover a light emitting surface of the light emitting diode chip,
wherein the housing includes a first surface and a second surface which are perpendicular to a width direction of the housing and spaced apart from each other, and a third surface and a fourth surface which are perpendicular a longitudinal direction of the housing and spaced apart from each other, and
wherein the first surface and the second surface surround the resin part while the third surface and the fourth surface expose side surfaces of the resin part.

2. The light emitting diode package of claim 1, wherein the housing is formed of a silicon or epoxy material having a white color.

3. The light emitting diode package of claim 1, wherein the housing includes:
a mounting portion on which the light emitting diode chip is mounted;
a first sidewall portion and a second sidewall portion extending from the mounting portion toward one end and the other end in the width direction of the housing, respectively;
a first step portion extending from the first sidewall portion to the first surface and a second step portion extending from the second sidewall portion to the second surface;
a third sidewall portion and a fourth sidewall portion extending from the mounting portion toward one end and the other end in the longitudinal direction of the housing, respectively; and
a third step portion extending from the third sidewall portion to the third surface and a fourth step portion extending from the fourth sidewall portion to the fourth surface.

4. The light emitting diode package of claim 3, wherein the mounting portion includes a flat surface,
the third and fourth sidewall portions include inclined surfaces having a first inclination angle, and the first and second sidewall portions include inclined surfaces having a second inclination angle, and
the first inclination angle has a smaller value than the second inclination angle.

5. The light emitting diode package of claim 3, wherein a first distance from a center of a mounting region of the light emitting diode chip to the third sidewall portion is greater than a second distance from the third sidewall portion to the third step portion, and the second distance is greater than a third distance from the third step portion to the third surface of the housing.

6. The light emitting diode package of claim 5, wherein a fourth distance from the first sidewall portion to the first step portion is smaller than the second distance from the third sidewall portion to the third step portion.

7. The light emitting diode package of claim 5, wherein the light emitting diode chip is disposed at a center of the cavity region in the width direction of the housing, and is disposed close to the third sidewall portion or the fourth sidewall portion at the center of the cavity region in the longitudinal direction of the housing.

8. The light emitting diode package of claim 1, further comprising:
electrodes electrically connected to the light emitting diode chip,
wherein the electrodes are respectively exposed on the third surface and the fourth surface of the housing, each of the electrodes being disposed at a position spaced apart from a bottom surface of the housing by a preset height, and formed to be surrounded by the housing.

9. The light emitting diode package of claim 1, wherein a height of an exposed region of the resin part which is exposed through the third surface and the fourth surface of the housing is about 50% or less of an overall height of the light emitting diode package.

10. The light emitting diode package of claim 1, wherein the resin part has a structure in which an inner surface is depressed downward so that the resin part is exposed to emit light.

11. The light emitting diode package of claim 10, wherein the resin part includes a transparent silicon or a phosphor for wavelength conversion.

12. A light emitting diode package comprising:
a housing including a plurality of cavity regions therein and a partition wall formed between the cavity regions to separate the plurality of cavity regions;
a plurality of light emitting diode chips respectively mounted on one surfaces inside the plurality of cavity regions; and
a resin part formed in each of the cavity regions to cover a light emitting surface of each of the light emitting diode chips,
wherein the housing includes a first surface perpendicular to a width direction of the housing, a second surface parallel to the first surface, a third surface perpendicular to a longitudinal direction of the housing, and a fourth surface parallel to the third surface, and
wherein the first surface and the second surface surround the resin parts while the third surface and the fourth surface expose side surfaces of the resin parts.

13. The light emitting diode package of claim 12, wherein each of the cavity regions include:
a mounting portion on which the light emitting diode chip is mounted;
a first sidewall portion and a second sidewall portion extending from the mounting portion toward one end and the other end in the width direction of the housing, respectively;
a first step portion extending from the first sidewall portion to the first surface and a second step portion extending from the second sidewall portion to the second surface;
a third side wall portion or a fourth side wall portion extending from the mounting portion toward one end and the other end in the longitudinal direction of the housing, respectively; and
a third step portion extending from the third sidewall portion to the third surface or a fourth step portion extending from the fourth sidewall portion to the fourth surface.

14. The light emitting diode package of claim 13, wherein the light emitting diode chip is disposed at a center of the cavity region in the first direction and the second direction, and disposed closer to the third sidewall portion or the third sidewall portion in the third direction or the fourth direction at the center of the cavity region.

15. The light emitting diode package of claim 13, wherein an inclination angle of the partition wall is greater than an inclination angle of the third sidewall portion extending in the third direction or the fourth sidewall portion extending in the fourth direction of the housing.

16. The light emitting diode package of claim 13, wherein the partition wall has a height higher than that of the third step portion and the fourth step portion.

17. The light emitting diode package of claim 13, wherein the plurality of light emitting diode chips includes two light emitting diode chips, the two light emitting diode chips are mounted with the partition wall interposed therebetween, and the two light emitting diode chips are surrounded by a structure having an open end surface, an electrode being exposed through the open end surface.

18. A backlight unit comprising:
a plurality of light emitting diode packages for emitting light in at least three directions;
a circuit board on which the light emitting diode packages are mounted;
a light guide plate for changing a path of light incident from the light emitting diode packages;
a reflective sheet disposed on a lower surface of the light guide plate; and
at least one optical sheet disposed on an upper surface of the light guide plate,
wherein each of the light emitting diode packages includes:
a housing including a cavity region therein;
a light emitting diode chip mounted on one surface of the cavity of the housing; and
a resin part formed in the cavity region to cover a light emitting surface of the light emitting diode chip,
wherein the housing includes a first surface perpendicular to a width direction of the housing, a second surface parallel to the first surface, a third surface perpendicular to a longitudinal direction of the housing, and a fourth surface parallel to the third surface including,
wherein the first surface and the second surface surround the resin part while the third surface and the fourth surface expose side surfaces of the resin part, and
wherein the adjacent light emitting diode packages are arranged in such a way that the exposed side surfaces of the resin parts face each other.

19. The backlight unit of claim 18, wherein the housing includes:
a mounting portion on which the light emitting diode chip is mounted;
a first sidewall portion and a second sidewall portion extending from the mounting portion toward one end and the other end in the width direction of the housing, respectively;
a first step portion extending from the first sidewall portion to the first surface and a second step portion extending from the second sidewall portion to the second surface;
a third side wall portion and a fourth side wall portion extending from the mounting portion toward one end and the other end in the longitudinal direction of the housing, respectively; and
a third step portion extending from the third sidewall portion to the third surface and a fourth step portion extending from the fourth sidewall portion to the fourth surface.

20. The backlight unit of claim 18, wherein the cavity region of the housing includes a plurality of cavity regions, and the housing further includes a partition wall formed between the cavity regions to separate the plurality of cavity regions.
